# EUROPEAN PATENT SPECIFICATION

(11) **EP 4 198 378 B1**
(45) Date of publication and mention of the grant of the patent: **07.05.2025**
(21) Application number: 21863407.9
(22) Date of filing: 23.07.2021
(51) Int. Cl.: H05K 1/18

(54) **LED PATCH FLEXIBLE-WIRE LIGHT HAVING SERIES-PARALLEL STRUCTURE**
FLEXIBLE DRAHTLEUCHTE MIT SERIENPARALLELER STRUKTUR FÜR LED-PATCH
LAMPE À CÂBLES FLEXIBLES À PLAQUES DE DEL AYANT UNE STRUCTURE SÉRIE-PARALLÈLE

(30) Priority: 02.09.2020 CN 202010909848
(43) Date of publication of application: 21.06.2023
(73) Proprietor: Hangzhou Yun Led Chip Photoelectricity Tech.Co., Ltd., Hangzhou, Zhejiang 311121 (CN)
(72) Inventor: YANG, Yinghan, Hangzhou, Zhejiang 311121 (CN); ZHANG, Zixun, Hangzhou, Zhejiang 311121 (CN)
(74) Representative: Grünecker Patent- und Rechtsanwälte PartG mbB
(86) International application number: PCT/CN2021/108091
(87) International publication number: WO 2022/048339

(56) References cited:
- CN-A- 103 499 045
- CN-A- 109 798 495
- CN-A- 110 617 414
- CN-A- 110 726 081
- CN-A- 110 726 082
- CN-A- 110 736 034
- CN-A- 110 736 034
- CN-A- 111 998 252
- CN-U- 204 328 616
- US-A1- 2008 200 089
- US-A1- 2021 071 854
- US-B2- 11 339 957

## Description

### TECHNICAL FIELDS

The present invention relates to the technical field of LED Color lights, and specifically relates to an LED flexible wire light in parallel-series connection.

### BACKGROUND

At present, DIP-LED Color lights on the market can be manufactured automatically by machines in parallel-series connection or in series-parallel connection. The current of color lights could be decreased to minimize wire losses by higher supply voltage in parallel-series connection or in series-parallel connection.

It is difficult to reach a high waterproof level for DIP-LED lights in parallel-series connection or in series-parallel connection because the structure characteristic of DIP-LED is hard to anti-water, although these DIP-LED lights are used broadly. And it is hard to decrease the cost of DIP-LED lights for low manufacturing efficiency.

Recently, SMD lights, such as copper lights, are used broadly in the LED color light market. SMD LEDs on a copper light are mounted on two copper wires by machine at welding positions with non-conductive protection opened. The two copper wires are non-conductive to each other. SMD LEDs are encapsulated by solidified material. Those are disclosed in Chinese Patent CN209325702U and CN202756984U.

The efficiency is increased by copper light automatic manufacture. But, it is still low efficiency to manually connect copper lights in parallel-series connection or in series-parallel connection.

CN 110 736 034 A discloses a LED flexible tube lamp comprising a LED lamp string, wherein the LED lamp string comprises a first lead wire, a second lead wire, a third lead wire, a plurality of SMD LEDs and a plurality of packaging colloids; insulating layers on the surfaces of the first lead wire and the second lead wire are removed along axial directions of the first lead wire and the second lead wire according to set length intervals, thereby forming a plurality of first weld spots and second weld spots; two weldlegs of the plurality of SMD LEDs are mounted on the plurality of first weld spots and the plurality of second weld spots; the plurality of SMD LEDs and the surface of the third lead wire corresponding to the positions of the SMD LEDs are coated by the plurality of packaging colloids. The LED flexible tube lamp also comprises a flexible lamp tube.

It is the object of the present invention to improve the manufacturing efficiency and tensile strength of LED wires.

This object is solved by the subject matter of the independent claims.

Embodiments are defined in the dependent claims.

To improve the manufacturing efficiency of LED lights in parallel-series connection, an LED flexible wire light in parallel-series connection is disclosed in the present invention.

An LED flexible wire light in parallel-series connection comprises: a first flexible wire, a second flexible wire, a third flexible wire, and a plurality of surface-mounted device (SMD) LED groups;
said first flexible wire, said second flexible wire and said third flexible wire are enclosed by non-conductive material without any conduction to each other;
said plurality of SMD LED groups are numbered in the order of first SMD LED group, second SMD LED group, ..., Nth SMD LED group; said SMD LED groups with odd numbers are odd SMD LED groups, said SMD LED groups with even numbers are even SMD LED groups;
said plurality of SMD LED groups are electrically connected between said first flexible wire and said second flexible wire in the order of said SMD LED groups' number; the anodes of said odd SMD LED groups are electrically connected to said first flexible wire, the cathodes of said odd SMD LED groups are electrically connected to said second flexible wire; the cathodes of said even SMD LED groups are electrically connected to said first flexible wire, the anodes of said even SMD LED groups are electrically connected to said second flexible wire; said first flexible wire is cut to non-conduction at each point between the anode of said odd SMD LED group and the cathode of the next even SMD group; said second flexible wire is cut to non-conduction at each point between the anode of said even SMD LED group and the cathode of the next odd SMD group; the cathode of said Nth LED group is electrically connected to said third flexible wire; said third flexible wire is the cathode of said LED flexible wire light, and said first flexible wire is the anode of said LED flexible wire light;
alternatively: said plurality of SMD LED groups are electrically connected between said first flexible wire and said second flexible wire in the order of said SMD LED groups' number; the cathode of said odd SMD LED groups are electrically connected to said first flexible wire, the anode of said odd SMD LED groups are electrically connected to said second flexible wire; the anode of said even SMD LED groups are electrically connected to said first flexible wire, the cathode of said even SMD LED groups are electrically connected to said second flexible wire; said first flexible wire is cut to non-conduction at each point between the cathode of said odd SMD LED group and the anode of the next even SMD group; said second flexible wire is cut to non-conduction at each point between the cathode of said even SMD LED group and the anode of the next odd SMD group; the anode of said Nth LED group is electrically connected to said third flexible wire; said third flexible wire is the anode of said LED flexible wire light, and said first flexible wire is the cathode of said LED flexible wire light.

Said first flexible wire, said second flexible wire, and said third flexible wire are a single conductive metal wire respectively, or a plurality of twisted conductive metal wires respectively.

All SMD LEDs in each SMD LED group are welded in parallel in the same way. The anode of an SMD LED group is the common anode of all SMD LEDs in an SMD LED group. The cathode of an SMD LED group is the common cathode of all SMD LEDs in an SMD LED group.

There are more than two SMD LEDs in said first SMD LED group, said second SMD LED group, ..., or said Nth SMD LED group. The numbers of SMD LEDs in each of said SMD LED groups can be equal or unequal. In some embodiments, the numbers of SMD LEDs in said first SMD LED group, said second SMD LED group, ..., or said Nth SMD LED group are equal. The anode of an SMD LED group is to electrically connect all SMD LED anodes in an SMD LED group in parallel. The cathode of an SMD LED group is to electrically connect all SMD LED cathodes in an SMD LED group in parallel.

Said first flexible wire, said second flexible wire, and said third flexible wire can be arranged in any combinations. In some embodiments, said first flexible wire, said second flexible wire and said third flexible wire are adhered and fixed by a non-conductive material. Said first flexible wire, said second flexible wire, and said third flexible wire can be manufactured in mass because these wires are adhered and fixed by said non-conductive material. The tensile strength and the waterproofing ability are improved because these wires are adhered and fixed by said non-conductive material.

In a common way, a current loop wire is connected and welded manually without any machine automation for LED lights in parallel-series connection. Said third flexible wire can be connected and welded automatically by machines as the necessary current loop wire because said first flexible wire, said second flexible wire and said third flexible wire are adhered and fixed by said non-conductive material. Said first flexible wire, said second flexible wire, and said third flexible wire can be conveniently manufactured as a whole in mass because those wires are adhered and fixed by said non-conductive material, thus LED flexible wire lights in parallel-series connection can be manufactured automatically by machines.

In some embodiments, said first flexible wire, said second flexible wire and said third flexible wire are arranged in the order as: said first flexible wire is adhered to said second flexible wire by said non-conductive material, said second flexible is adhered to said third flexible wire by said non-conductive material. The automatic control for light manufacture is easier because that the manufacture activity is almost on said first flexible wire and said second flexible wire by the ordered arrangement of said first flexible wire, said second flexible wire and said third flexible wire.

In some embodiments, said each point cut to non-conduction of said first flexible wire and said second flexible wire is fixed by non-conduction structure between adjacent said SMD LED groups. The tensile strength of the LED flexible wire light is enhanced for the said non-conductive structure.

In some embodiments, said non-conductive structure is a kind of transparent non-conductive structure solidified from a flexible material dripped by a machine while said flexible wire light is manufactured.

In some embodiments, a plurality of points on said first flexible wire and said second flexible wire are open as welding points where said SMD LEDs in each of said SMD LED groups are mounted and welded.

In some embodiments, said welding points on said first flexible wire and said second flexible wire are opened from said non-conductive material by mechanical friction. In some embodiments, one SMD LED is welded on one said welding point. In some embodiments, two or more SMD LEDs are welded on one said welding point.

In some embodiments, said welding points on said first flexible wire and said second flexible wire are opened from said non-conductive material by laser ablation.

Said SMD LEDs are encapsulated by a transparent non-conductive structure which is solidified from a flexible material dripped by machine onto said welding points.

In the invention patent, an LED flexible wire light in parallel-series connection is disclosed for machine automatic manufacture. The manual welding connection is reduced for an LED flexible wire light in parallel-series connection. The efficiency is higher, and the manufacturing cost is lower. And the tensile strength of lights in parallel-series connection is improved. Thus, the LED flexible wire light in parallel-series connection can be manufactured in mass.

### BRIEF DESCRIPTION OF DRAWINGS

FIG. 1 illustrates an LED flexible wire light in parallel-series connection;
FIG. 2 illustrates the cross-section of an LED flexible wire light in parallel-series connection.

### DETAILED DESCRIPTION

In the following, with reference to the drawings of various embodiments disclosed herein, the technical solutions of the embodiments of the disclosure will be described in detail.

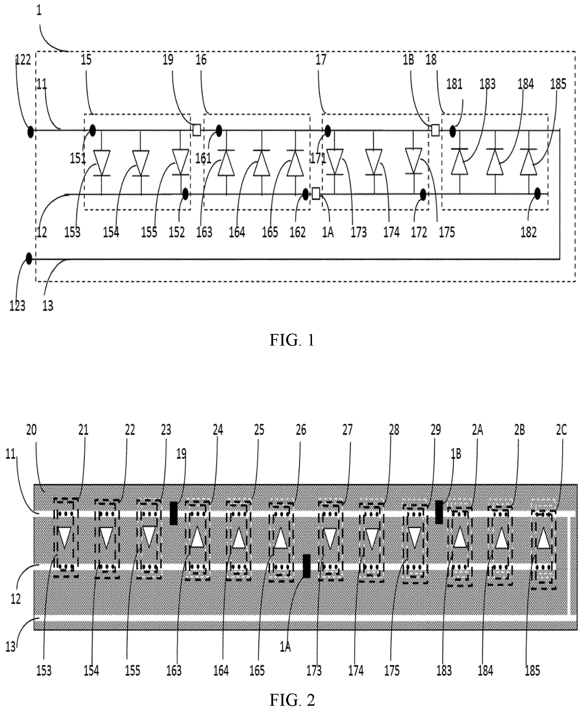

As illustrated in FIG. 1, an implemented LED flexible wire light in parallel-series connection 1, comprises:
a first flexible wire 11, a second flexible wire 12, a third flexible wire 13, and four SMD LED groups. The four SMD LED groups are numbered as first SMD LED group 15, second SMD LED group 16, third SMD LED group 17, and fourth SMD LED group 18. First SMD LED group 15 and third SMD LED group 17 are odd SMD LED groups. Second SMD LED group 16 and fourth SMD LED group 18 are even SMD LED groups.

The anode 151 of the first SMD LED group 15 is connected to the first flexible wire 11, and the cathode 152 is connected to the second flexible wire 12;

The cathode 161 of the second SMD LED group 16 is connected to first flexible wire 11, and the anode 162 is connected to the second flexible wire 12. The point 19 between the anode 151 of the first SMD LED group 15 and the cathode 161 of the second SMD LED group 16 is cut to non-conduction.

The anode 171 of the third SMD LED group 17 is connected to the first flexible wire 11, and the cathode 172 of third SMD LED group 17 is connected to the second flexible wire 12. The point 1A between the anode 162 of the second SMD LED group 16 and the cathode 172 of third SMD LED group 17 is cut to non-conduction.

The cathode 181 of the fourth SMD LED group 18 is connected to the first flexible wire, and the anode 182 of fourth SMD LED group 18 is connected to the second flexible wire 12. The point 1B between the anode 171 of the third SMD LED group 17 and the cathode 181 of the fourth SMD LED group 18 is cut to non-conduction.

The cathode 181 of fourth SMD LED group 18 is welded and connected to third flexible wire 13.

As illustrated in FIG. 1, in the implemented LED flexible wire light 1, first SMD LED group 15 comprises three SMD LEDs with 0807 size: 153, 154, and 155 respectively; second SMD LED group 16 comprises three SMD LEDs with 0807 size: 163, 164, and 165 respectively; third SMD LED group 17 comprises three SMD LEDs with 0807 size: 173, 174, and 175 respectively; fourth SMD LED group 18 comprises three SMD LEDs with 0807 size: 183, 184, and 185 respectively.

The anode 122 of the implemented LED flexible wire light 1 is the anode 151 of first SMD LED group 15, and the cathode 123 of the implemented LED flexible wire light 1 is the third flexible wire 13.

FIG. 2 illustrates the cross-section of an LED flexible wire light 1 in parallel-series connection. The first flexible wire 11, the second flexible wire 12, and the third flexible wire 13 are arranged in orderly. The first flexible wire 11 and the second flexible wire 12 are fixed and adhered by a non-conductive material 20, the second flexible wire 12 and the third flexible wire 13 are fixed and adhered by the non-conductive material 20.

As FIG. 2 illustrates, there are twelve welding points 21, 22, 23, 24, 25, 26, 27, 28, 29, 2A, 2B, 2C on the first flexible wire 11 and the second flexible wire 12 opened from the non-conductive material 20 by laser ablation. The space between two adjacent welding points are 10 cm apart.

As FIG. 2 illustrates, the three SMD LEDs with 0807 size in first SMD LED group 15 are welded on the welding points 21, 22, 23; the anodes of the three SMD LEDs are welded on the first flexible wire 11, the cathodes of the three SMD LEDs are welded on the second flexible wire 12. The three SMD LEDs with 0807 size in second SMD LED group 16 are welded on the welding points 24, 25, 26; the cathodes of the three SMD LEDs are welded on the first flexible wire 11, the anodes of the three SMD LEDs are welded on the second flexible wire 12. The three SMD LEDs with 0807 size in the third SMD LED group 17 are welded on the welding points 27, 28, 29; the anodes of the three SMD LEDs are welded on the first flexible wire 11, the cathodes of the three SMD LEDs are welded on the second flexible wire 12. The three SMD LEDs with 0807 size in fourth SMD LED group 18 are welded on the welding points 2A, 2B, 2C; the cathodes of the three SMD LEDs are welded on the first flexible wire 11, the anodes of the three SMD LEDs are welded on the second flexible wire 12.

As FIG. 2 illustrates, the point 19, the point 1A and the point 1B are fixed by a kind of transparent non-conductive structure that is solidified from a flexible material dripped by machine while said flexible wire light is being manufactured. The transparent non-conductive structure is to enhance the resistance to a tension of lights in parallel-series connection and is to cut the current path.

The LED flexible wire light in parallel-series connection is implemented for machine automatic manufacture. The manual welding connection is reduced(less). The efficiency is higher.

It is only a preferred embodiment that is not intended to limit the invention patent. Based on the described embodiments of the disclosure, any other embodiment(s), which come(s) from any modification, substitution, and improvement within the scope should be sought for protection by the disclosure.

## Claims

1. An LED flexible wire light (1) in parallel-series connection, comprising: a first flexible wire (11), a second flexible wire (12), a third flexible wire (13) and a plurality of SMD LED groups;
said first flexible wire (11), said second flexible wire (12) and said third flexible wire (13) are enclosed by non-conductive material without any conduction to each other;
said plurality of SMD LED groups (15, 16, 17, 18) are numbered as first SMD LED group (15), second SMD LED group (16), ..., Nth SMD LED group; said SMD LED groups with odd numbers are odd SMD LED groups (15, 17), said SMD LED groups with even numbers are even SMD LED groups (16, 18);
wherein either:
said plurality of SMD LED groups are connected electrically between said first flexible wire (11) and said second flexible wire (12) in the order of said SMD LED groups' number; anodes (151, 171) of said odd SMD LED groups (15, 17) are electrically connected to said first flexible wire (11), cathodes (152, 172) of said odd SMD LED groups (15, 17) are electrically connected to said second flexible wire (12); cathodes (161, 181) of said even SMD LED groups (16, 18) are electrically connected to said first flexible wire (11), anodes (162, 182) of said even SMD LED groups (16, 18) are electrically connected to said second flexible wire (12); said first flexible wire (11) is cut to non-conduction at each point between an anode of said odd SMD LED group and a cathode of next even SMD group; said second flexible wire (12) is cut to non-conduction at each point between an anode of said even SMD LED group and a cathode of next odd SMD group; a cathode of said Nth LED group is electrically connected to said third flexible wire (13); said third flexible wire (13) is the cathode of said LED flexible wire light, and said first flexible wire (11) is the anode of said LED flexible wire light, or alternatively:
said plurality of SMD LED groups (15, 16, 17, 18) are connected electrically between said first flexible wire (11) and said second flexible wire (12) in the order of said SMD LED groups' number; a cathode (152, 172) of said odd SMD LED groups (15, 17) are electrically connected to said first flexible wire (11), an anode (151, 172) of said odd SMD LED groups (15, 17) are electrically connected to said second flexible wire (12); an anode (162, 182) of said even SMD LED groups (16, 18) are electrically connected to said first flexible wire (11), a cathode (161, 181) of said even SMD LED groups (16, 18) are electrically connected to said second flexible wire (12); said first flexible wire (11) is cut to non-conduction at each point between a cathode of said odd SMD LED group and an anode of the next even SMD group; said second flexible wire (12) is cut to non-conduction at each point between a cathode of said even SMD LED group and an anode of the next odd SMD group; an anode of said Nth LED group is electrically connected to said third flexible wire (13); said third flexible wire (13) is the anode of said LED flexible wire light in parallel-series, and said first flexible wire (11) is the cathode of said LED flexible wire light in parallel-series,
**characterised in that**
said each point cut to non-conduction of said first flexible wire (11) and said second flexible wire (12) is fixed by a non-conductive structure.

2. The LED flexible wire light in parallel-series of Claim 1, wherein said first flexible wire (11), said second flexible wire (12) and said third flexible wire (13) are adhered and fixed by non-conductive material (20).

3. The LED flexible wire light in parallel-series of Claim 2, wherein said first flexible wire (11), said second flexible wire (12) and said third flexible wire (13) are adhered in order as: said second flexible wire (12) is next to said first flexible wire (11), said third flexible wire (13) is next to said second flexible wire (12); said first flexible wire (11) is adhered to said second flexible wire (12) by said non-conductive material, said second flexible wire (12) is adhered to said third flexible wire (13) by said non-conductive material (20).

4. The LED flexible wire light in parallel-series of Claim 2, wherein said non-conductive structure is a kind of transparent non-conductive structure solidified from a flexible material dripped by machine while said flexible wire light is manufacturing.

5. The LED flexible wire light in parallel-series of Claim 4, wherein a plurality of points on said first flexible wire (11) and said second flexible wire (12) are opened from said non-conductive material as welding points where said SMD LEDs in each said SMD LED groups are mounted and welded.

6. The LED flexible wire light in parallel-series of Claim 5, wherein said SMD LEDs are encapsulated by a transparent non-conductive structure which is solidified from a flexible material dripped by machine at said welding points.

7. The LED flexible wire light in parallel-series of Claim 1, wherein there are more than 2 SMD LEDs in said first SMD LED group (15), said second SMD LED group (16), ..., and said Nth SMD LED group; there are same number of SMD LEDs in said first SMD LED group (15), said second SMD LED group (16), ..., and said Nth SMD LED group.

## Patentansprüche

1. Flexible LED-Drahtleuchte (1) in Parallel-Serienschaltung, die umfasst: einen ersten flexiblen Draht (11), einen zweiten flexiblen Draht (12), einen dritten flexiblen Draht (13) und eine Vielzahl von oberflächenmontierten SMD-LED-Gruppen;
wobei der erste flexible Draht (11), der zweite flexible Draht (12) und der dritte flexible Draht (13) von einem nichtleitenden Material ohne Verbindung zueinander umschlossen sind;
wobei die Vielzahl von SMD-LED-Gruppen (15, 16, 17, 18) in der Reihenfolge erste SMD-LED-Gruppe (15), zweite SMD-LED-Gruppe (16), ..., N-te SMD-LED-Gruppe nummeriert sind; die SMD-LED-Gruppen mit ungeraden Nummern ungerade SMD-LED-Gruppen (15, 17) sind, die SMD-LED-Gruppen mit geraden Nummern gerade SMD-LED-Gruppen (16, 18) sind;
wobei entweder:
die Vielzahl von SMD-LED-Gruppen elektrisch zwischen dem ersten flexiblen Draht (11) und dem zweiten flexiblen Draht (12) in der Reihenfolge der Nummer der SMD-LED-Gruppen verbunden sind; Anoden (151, 171) der ungeraden SMD-LED-Gruppen (15, 17) elektrisch mit dem ersten flexiblen Draht (11) verbunden sind, Kathoden (152, 172) der ungeraden SMD-LED-Gruppen (15 ,17) elektrisch mit dem zweiten flexiblen Draht (12) verbunden sind; Kathoden (161, 181) der geraden SMD-LED-Gruppen (16, 18) elektrisch mit dem ersten flexiblen Draht (11) verbunden sind, Anoden (162, 182) der geraden SMD-LED-Gruppen (16, 18) elektrisch mit dem zweiten flexiblen Draht (12) verbunden sind; der erste flexible Draht (11) an jedem Punkt zwischen einer Anode der ungeraden SMD-LED-Gruppe und einer Kathode der nächsten geraden SMD-Gruppe auf Nichtleitung geschnitten ist; der zweite flexible Draht (12) an jedem Punkt zwischen einer Anode der geraden SMD-LED-Gruppe und einer Kathode der nächsten ungeraden SMD-Gruppe auf Nichtleitung geschnitten ist; eine Kathode der N-ten LED-Gruppe elektrisch mit dem dritten flexiblen Draht (13) verbunden ist; der dritte flexible Draht (13) die Kathode der flexiblen LED-Drahtleuchte ist und der erste flexible Draht (11) die Anode der flexiblen LED-Drahtleuchte ist;
oder wobei alternativ:
die Vielzahl von SMD-LED-Gruppen (15, 16, 17, 18) elektrisch zwischen dem ersten flexiblen Draht (11) und dem zweiten flexiblen Draht (12) in der Reihenfolge der Nummer der SMD-LED-Gruppen verbunden ist; eine Kathode (152, 172) der ungeraden SMD-LED-Gruppen (15, 17) elektrisch mit dem ersten flexiblen Draht (11) verbunden ist, eine Anode (151, 172) der ungeraden SMD-LED-Gruppen (15, 17) elektrisch mit dem zweiten flexiblen Draht (12) verbunden ist; eine Anode (162, 182) der geraden SMD-LED-Gruppen (16, 18) elektrisch mit dem ersten flexiblen Draht (11) verbunden ist, eine Kathode (161, 181) der geraden SMD-LED-Gruppen (16, 18) elektrisch mit dem zweiten flexiblen Draht (12) verbunden ist; der erste flexible Draht (11) an jedem Punkt zwischen einer Kathode der ungeraden SMD-LED-Gruppe und einer Anode der nächsten geraden SMD-Gruppe auf Nichtleitung geschnitten ist; der zweite flexible Draht (12) an jedem Punkt zwischen einer Kathode der geraden SMD-LED-Gruppe und einer Anode der nächsten ungeraden SMD-Gruppe auf Nichtleitung geschnitten ist; eine Anode der N-ten LED-Gruppe elektrisch mit dem dritten flexiblen Draht (13) verbunden ist; der dritte flexible Draht (13) die Anode der flexiblen LED-Drahtleuchte in Parallel-Serie ist und der erste flexible Draht (11) die Kathode der flexiblen LED-Drahtleuchte in Parallel-Serie ist,
**dadurch gekennzeichnet, dass** jeder Punkt, der zur Nichtleitung des ersten flexiblen Drahtes (11) und des zweiten flexiblen Drahtes geschnitten ist, durch eine nichtleitende Struktur fixiert ist.

2. Flexible LED-Drahtleuchte in Parallel-Serie nach Anspruch 1, wobei der erste flexible Draht (11), der zweite flexible Draht (12) und der dritte flexible Draht (13) durch nichtleitendes Material (20) angeklebt und befestigt sind.

3. Flexible LED-Drahtleuchte in Parallel-Serie nach Anspruch 2, wobei der erste flexible Draht (11), der zweite flexible Draht (12) und der dritte flexible Draht (13) in der folgenden Reihenfolge angeklebt sind: der zweite flexible Draht (12) befindet sich neben dem ersten flexiblen Draht (11), der dritte flexible Draht (13) befindet sich neben dem zweiten flexiblen Draht (12); der erste flexible Draht (11) ist an den zweiten flexiblen Draht (12) durch das nichtleitende Material geklebt, der zweite flexible Draht (12) ist an den dritten flexiblen Draht (13) durch das nichtleitende Material (20) geklebt.

4. Flexible LED-Drahtleuchte in Parallel-Serie nach Anspruch 2, wobei die nichtleitende Struktur eine Art transparente, nichtleitende Struktur ist, die aus einem flexiblen Material verfestigt wird, das von einer Maschine bei der Herstellung der flexiblen Drahtleuchte aufgetropft wird.

5. Flexible LED-Drahtleuchte in Parallel-Serie nach Anspruch 4, wobei eine Vielzahl von Punkten an dem ersten flexiblen Draht (11) und dem zweiten flexiblen Draht (12) aus dem nichtleitenden Material als Schweißpunkte geöffnet werden, an denen die SMD-LEDs in jeder SMD-LED-Gruppe angebracht und verschweißt sind.

6. Flexible LED-Drahtleuchte in Parallel-Serie nach Anspruch 5, wobei die SMD-LEDs von einer transparenten, nichtleitenden Struktur gekapselt sind, die aus einem flexiblen Material verfestigt wird, das von einer Maschine an den Schweißpunkten aufgetropft wird.

7. Flexible LED-Drahtleuchte in Parallel-Serie nach Anspruch 1, wobei mehr als 2 SMD-LEDs in der ersten SMD-LED-Gruppe (15), der zweiten SMD-LED-Gruppe (16), ..., und der N-ten SMD-LED-Gruppe vorhanden sind; wobei dieselbe Anzahl von SMD-LEDs in der ersten SMD-LED-Gruppe (15), der zweiten SMD-LED-Gruppe (16), ..., und der N-ten SMD-LED-Gruppe vorhanden ist.

## Revendications

1. Lampe à fil flexible à diodes électroluminescentes DEL (1) en connexion parallèle-série, comprenant :
un premier fil flexible (11), un deuxième fil flexible (12), un troisième fil flexible (13) et une pluralité de groupes de DEL comme composants montés en surface, CMS ;
ledit premier fil flexible (11), ledit deuxième fil flexible (12) et ledit troisième fil flexible (13) étant entourés d'un matériau non conducteur, sans aucune conduction les uns avec les autres ;
les groupes de ladite pluralité de groupes de DEL CMS (15, 16, 17, 18) étant numérotés comme premier groupe de DEL CMS (15), deuxième groupe de DEL CMS (16), ..., Nième groupe de DEL CMS ; lesdits groupes de DEL CMS avec des numéros impairs étant des groupes de DEL CMS impairs (15, 17), lesdits groupes de DEL CMS avec des numéros pairs sont des groupes de DEL CMS pairs (16, 18) ;
dans laquelle soit :
les groupes de ladite pluralité de groupes de DEL CMS sont connectés électriquement entre ledit premier fil flexible (11) et ledit deuxième fil flexible (12) dans l'ordre du numéro desdits groupes de DEL CMS ; les anodes (151, 171) desdits groupes de DEL CMS impairs (15, 17) sont connectées électriquement audit premier fil flexible (11), les cathodes (152, 172) desdits groupes de DEL CMS impairs (15, 17) étant connectées électriquement audit deuxième fil flexible (12) ; les cathodes (161, 181) desdits groupes de DEL CMS pairs (16, 18) sont connectées électriquement audit premier fil flexible (11), les anodes (162, 182) desdits groupes de DEL CMS pairs (16, 18) étant connectées électriquement audit deuxième fil flexible (12) ; ledit premier fil flexible (11) est coupé jusqu'à une non-conduction à chaque point situé entre une anode dudit groupe de DEL CMS impair et une cathode du groupe CMS pair suivant ; ledit deuxième fil flexible (12) est coupé jusqu'à une non-conduction à chaque point situé entre une anode dudit groupe de DEL CMS pair et une cathode du groupe CMS impair suivant ; une cathode dudit Nième groupe de DEL est connectée électriquement audit troisième fil flexible (13) ; ledit troisième fil flexible (13) est la cathode de ladite lampe à fil flexible à DEL, et ledit premier fil flexible (11) est l'anode de ladite lampe à fil flexible à DEL, ou autrement :
les groupes de ladite pluralité de groupes de DEL CMS (15, 16, 17, 18) sont connectés électriquement entre ledit premier fil flexible (11) et ledit deuxième fil flexible (12) dans l'ordre desdits numéros des groupes de DEL CMS ; une cathode (152, 172) desdits groupes de DEL CMS impairs (15, 17) est connectée électriquement audit premier fil flexible (11), une anode (151, 172) desdits groupes de DEL CMS impairs (15, 17) est connectée électriquement audit deuxième fil flexible (12) ; une anode (162, 182) desdits groupes de DEL CMS pairs (16, 18) est connectée électriquement audit premier fil flexible (11), une cathode (161, 181) desdits groupes de DEL CMS pairs (16, 18) est connectée électriquement audit deuxième fil flexible (12) ; ledit premier fil flexible (11) est coupé jusqu'à une non-conduction à chaque point situé entre une cathode dudit groupe de DEL CMS impair et une anode du groupe CMS pair suivant ; ledit deuxième fil flexible (12) est coupé jusqu'à une non-conduction à chaque point situé entre une cathode dudit groupe de DEL CMS pair et une anode du groupe CMS impair suivant ; une anode dudit Nième groupe de DEL est connectée électriquement audit troisième fil flexible (13); ledit troisième fil flexible (13) est l'anode de ladite lampe à fil flexible à DEL parallèle-série, et ledit premier fil flexible (11) est la cathode de ladite lampe à fil flexible à DEL parallèle-série,
**caractérisée en ce que** chaque dit point coupé jusqu'à une non-conduction dudit premier fil flexible (11) et dudit deuxième fil flexible (12) est fixé par une structure non conductrice.

2. Lampe à fil flexible à DEL parallèle-série selon la revendication 1, dans laquelle ledit premier fil flexible (11), ledit deuxième fil flexible (12) et ledit troisième fil flexible (13) sont collés et fixés par un matériau non conducteur (20).

3. Lampe à fil flexible à DEL parallèle-série selon la revendication 2, dans laquelle ledit premier fil flexible (11), ledit deuxième fil flexible (12) et ledit troisième fil flexible (13) sont collés dans l'ordre suivant : ledit deuxième fil flexible (12) est adjacent audit premier fil flexible (11), ledit troisième fil flexible (13) est adjacent audit deuxième fil flexible (12) ; ledit premier fil flexible (11) est collé audit deuxième fil flexible (12) par ledit matériau non conducteur, ledit deuxième fil flexible (12) est collé audit troisième fil flexible (13) par ledit matériau non conducteur (20).

4. Lampe à fil flexible à DEL parallèle-série selon la revendication 2, dans laquelle ladite structure non conductrice est une sorte de structure non conductrice transparente solidifiée à partir d'un matériau flexible déposé goutte à goutte par une machine pendant la fabrication de ladite lampe à fil flexible.

5. Lampe à fil flexible à DEL parallèle-série selon la revendication 4, dans laquelle une pluralité de points sur ledit premier fil flexible (11) et ledit deuxième fil flexible (12) sont ouverts à partir dudit matériau non conducteur en tant que points de soudure où lesdites DEL CMS dans chacun desdits groupes de DEL CMS sont montées et soudées.

6. Lampe à fil flexible à DEL parallèle-série selon la revendication 5, dans laquelle lesdites DEL CMS sont encapsulées par une structure non conductrice transparente qui est solidifiée à partir d'un matériau flexible déposé goutte à goutte par une machine auxdits points de soudure.

7. Lampe à fil flexible à DEL parallèle-série selon la revendication 1, dans laquelle il y a plus de 2 DEL CMS dans ledit premier groupe de DEL CMS (15), ledit deuxième groupe de DEL CMS (16), ..., et ledit Nième groupe de DEL CMS ; il y a le même nombre de DEL CMS dans ledit premier groupe de DEL CMS (15), ledit deuxième groupe de DEL CMS (16), ..., et ledit Nième groupe de DEL CMS.
